# FASCICULE DE BREVET EUROPEEN

(11) **EP 0 916 488 B1**
(45) Date de publication et mention de la délivrance du brevet: **03.04.2002**
(21) Numéro de dépôt: 98203714.5
(22) Date de dépôt: 03.11.1998
(51) Int. Cl.: B41F 15/42, B41F 15/46, H05K 3/12

(54) **Système de sérigraphie automatique**
Automatisches Siebdrucksystem
Automatic screen printing system

(30) Priorité: 13.11.1997 FR 9714247
(43) Date de publication de la demande: 19.05.1999
(73) Titulaire: Koninklijke Philips Electronics N.V., 5621 BA Eindhoven (NL)
(72) Inventeur: Gasquez, Edouard, 75008 Paris (FR)
(74) Mandataire: Charpail, François

(56) Documents cités:
- WO-A-92/04189
- DE-A- 3 812 826
- US-A- 4 216 716
- PATENT ABSTRACTS OF JAPAN vol. 18, no. 258 (M-1606), 17 mai 1994 -& JP 06 039999 A (MATSUSHITA ELECTRIC IND. CO. LTD.), 15 février 1994
- PATENT ABSTRACTS OF JAPAN vol. 18, no. 526 (M-1683), 5 octobre 1994 & JP 06 182967 A (DAINIPPON SCREEN MFG. CO. LTD.), 5 juillet 1994
- PATENT ABSTRACTS OF JAPAN vol. 17, no. 397 (M-1452), 26 juillet 1903 & JP 05 077393 A (AISIN SEIKI CO. LTD.), 30 mars 1993

## Description

L'invention concerne un système de sérigraphie automatique à deux lames de raclage selon le préambule de la revendication 1.

L'invention s'applique à la technique de sérigraphie en général et plus particulièrement à la technique qui consiste à déposer une pâte à souder sur des plages de contact d'un circuit imprimé ou céramique en vue de la soudure ultérieure de composants selon un procédé de refusion qui s'apparente au soudobrasage, technique particulièrement adaptée au CMS (Composants pour Montage en Surface). Dans cette application particulière préférée, la pâte à souder qui constitue le produit de sérigraphie est constituée par exemple de petites billes en un alliage de Pb-Sn de quelques microns de diamètre, agglomérées au moyen d'un liant qui confère à cette pâte des qualités thyxotropiques. L'écran est quant à lui fait d'une feuille mince en acier inoxydable de 180 µm ou 150 µm, munie d'alvéoles disposées au-dessus des plages de contact prévues sur le circuit imprimé ou céramique à enduire.

Pour rendre le procédé automatique, deux lames sont utilisées en opposition. Chaque lame, en acier souple, est fixée à un support et les deux supports de lame sont fermement serrés au moyen d'une pince de façon que les lames fassent, entre elles un angle de l'ordre de 90 degrés et un angle de 45 degrés environ, chacune, par rapport à l'écran. La pince est elle-même solidaire d'un chariot par rapport auquel elle peut basculer d'environ 10 degrés de part et d'autre d'une position médiane dans laquelle les lames font, en substance, le même angle par rapport à l'écran. En outre, un mouvement de translation vertical de la pince par rapport au chariot permet d'appliquer contre l'écran, avec une certaine pression prédéterminée nominale, l'une ou l'autre lame, après quoi le mouvement de translation horizontal qui permet l'opération de sérigraphie s'effectue sur un support à enduire, tel qu'un circuit imprimé. En fin de course, la pince est relevée, un bourrelet de pâte non consommée étant laissé sur l'écran par la lame qui était en action, puis la pince effectue un mouvement de basculement de façon à relever encore plus la première lame qui était en action et à rabaisser à une cote inférieure à celle de la première, celle qui était relevée et inactive au passage précédent du chariot. La pince s'abaisse ensuite jusqu'à ce que la deuxième lame soit appliquée contre l'écran avec ladite pression prédéterminée, le mouvement de translation du chariot recommence en sens inverse du précédent et le bourrelet de pâte laissé par la première lame est repris au passage par la deuxième lame et un nouveau support (circuit imprimé) est enduit. Lorsque la course horizontale du chariot se termine, les mêmes opérations de levage, basculement abaissement recommencent, symétriquement, les deux lames étant interchangées, et le cycle recommence. Au cours de ces opérations, du produit de sérigraphie (qu'on appellera plus généralement crème dans la suite du texte pour désigner une encre ou une pâte) est consommé par le produit à enduire et aussi, à chaque passage du chariot, une partie déborde latéralement, sur l'écran, aux deux extrémités de la lame. En conséquence, de la crème doit être rajoutée sur l'écran, périodiquement entre les deux lames, après un certain nombre de passages des lames.

Avec un tel système il se présente l'inconvénient que la crème qui a débordé aux extrémités des lames forme un cordon qui n'est jamais repris par les lames, cordon qui s'épaissit et sèche progressivement. Dans ces conditions, il est impossible de maîtriser les quantités de produit (de crème) effectivement consommé et de produit perdu. La crème involontairement évacuée sur les côtés perd de ses qualités de viscosité par évaporation des solvants et des liants qu'elle contient ; après un délai assez bref qui correspond à une vingtaine de passage des lames environ, cette crème serait définitivement inutilisable. Dans l'art connu, ce déplacement de la crème hors de la zone de travail impose une intervention manuelle fréquente pour redisposer le produit qui a débordé, ce qui est peu satisfaisant pour un système automatique.

Un autre inconvénient de l'art antérieur indiqué ci-dessus est que l'utilisation d'un système d'approvisionnement automatique de crème à sérigraphier est aléatoire, car la crème devenue inutilisable n'est pas facilement prise en compte étant donnée la difficulté qu'il y a à apprécier sa proportion par rapport à celle qui est réellement utilisée.

Pour pallier cet inconvénient, il est connu notamment de la demande de brevet EP-0 626 259, d'adjoindre des dispositifs d'arrêt antifuites aux extrémités latérales de la(des) lame(s) de raclage. Mais ces derniers sont orientés parallèlement au sens de déplacement des lames et le débordement latéral de la crème n'est pas totalement évité mais simplement retardé.

Les documents DE-38 12 826 et JP-06039999 décrivent des systèmes de sérigraphie comportant également des dispositifs d'arrêt antifuites aux extrémités latérales des lames de raclage.

Le but de l'invention est d'empêcher le débordement irréversible de la crème au-delà des bords latéraux de lames de raclage dans un système de sérigraphie automatique.

A cet effet les inconvénients de l'art antérieur sont atténués ou supprimés grâce au fait que le système de sérigraphie défini au premier paragraphe est remarquable en ce qu'il comporte les caractéristiques selon la partie caractérisante de la revendication 1.

L'idée de départ de l'invention est, tout en laissant un cordon de crème se former à chaque extrémité de lame lors d'un passage sur l'écran, que ce cordon soit repris lors du passage de lame suivant. Ainsi, à chaque passage de lame, la crème du cordon est remélangée avec la crème qui n'était pas encore passée en débordement lors du passage précédent et le cordon latéral conserve sensiblement la même grosseur, d'ailleurs minime, d'un passage de lame au passage suivant. La quantité de crème qui constitue le cordon latéral peut alors être considérée comme négligeable et il devient possible d'ajuster la quantité de crème à rajouter périodiquement de façon automatique entre les deux lames, après un nombre de passages de lame prédéterminé, étant donné que la quantité consommée par le support à enduire à chaque passage est connue avec précision. Le système peut ainsi fonctionner sans interruption pendant des heures et même des dizaines d'heures, sans perte de temps ni de produit à sérigraphier.

Comme il est expliqué plus loin, le montage de chaque joue doit être effectué avec soin car le bord libre qui est en appui contre l'écran doit être parfaitement horizontal, en liaison avec l'angle précis que fait la lame de raclage avec l'écran et la force d'application de ce bord libre doit être assez forte pour guider et recentrer toute la crème qui vient à son contact mais, en même temps, assez faible pour ne pas diminuer trop la pression que doit exercer l'extrémité de la lame pour entraîner dans son mouvement toute la crème qui vient à son contact.

Un perfectionnement avantageux de l'invention est remarquable en ce que le bord libre de chaque plaque est taillé en biseau, de l'extérieur vers l'intérieur du système de façon que seule une arête située le long de la face interne de la plaque soit au contact de l'écran, lors du fonctionnement.

Ainsi, lorsqu'une légère force est exercée sur le bord libre de la joue, l'arête qui est seule au contact de l'écran est légèrement repoussée vers l'intérieur du système et c'est contre elle que s'exerce toute la force précitée, ces deux caractéristiques étant favorables à un bon raclage avec cisaillement et guidage, jusque derrière la lame, de la crème en excès.

De préférence, l'invention s'applique à un système de sérigraphie automatique destiné à déposer une pâte à souder sur des plages de contact d'un circuit imprimé, dans lequel l'écran est constitué par une mince feuille en acier inoxydable munie d'alvéoles disposées au-dessus desdites plages de contact.

La description qui suit, en regard des dessins annexés, le tout donné à titre d'exemple non limitatif fera bien comprendre comment l'invention peut être réalisée.

La figure 1 représente de façon schématique avec arrachement un système de sérigraphie automatique à deux lames de raclage travaillant en opposition.

La figure 2 représente, avec arrachement, une partie d'un système de sérigraphie ne faisant pas partie de l'invention, en A vue de dessus et en B en section vue de droite.

La figure 3 illustre un premier mode de réalisation de l'invention, la figure 3 A représentant en vue de côté les moyens de fixation d'une joue et la figure 3 B représentant en perspective vue de dessous avec arrachement, une joue montée sur un support de lame.

La figure 4 illustre un deuxième mode de réalisation de l'invention, la figure 4 A représentant en perspective les moyens de fixation et la figure 4 B représentant vue en bout une joue montée.

La figure 5 illustre un mode de réalisation ne faisant pas partie de l'invention, la figure 5 A représentant en perspective la plaque en matériau souple constituant la joue et la figure 5 B représentant vue en bout, une joue montée.

La figure 6 représente avec arrachement en A le bord libre d'une joue, taillé en biseau et en B l'action de ce bord libre contre le produit de sérigraphie sur l'écran.

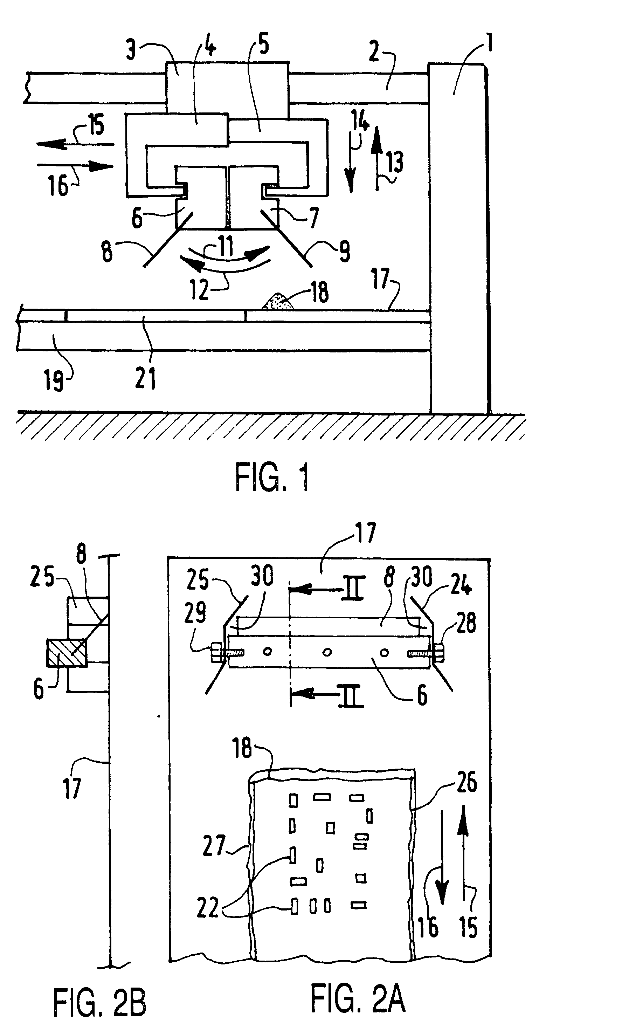

Le système de sérigraphie automatique de la figure 1 est constitué d'un portique comportant deux piliers verticaux tel que 1 (le pilier de gauche n'étant pas représenté) et une poutre horizontale 2 qui fait office de rail de support et de guidage pour un chariot 3. Le chariot 3 supporte lui-même une pince dont les mâchoires 4, 5 sont conçues pour enserrer fermement l'un contre l'autre deux supports (6, 7) pour des lames de raclage 8, 9 respectivement. L'ensemble, qui peut être considéré comme indéformable à l'état de serrage, constitué par les éléments 4 à 9 peut être soumis, par rapport au chariot 3, à des mouvements de rotation dans les deux sens indiqués par les flèches 11 et 12 selon des secteurs allant jusqu'à plusieurs dizaines de degrés. Cet ensemble peut aussi se déplacer selon un mouvement de translation vertical vers le haut ou vers le bas comme indiqué par les flèches 13 et 14. Des moyens mécaniques connus permettent les déplacements précités entre le chariot et la pince. Par ailleurs, le chariot 3 peut être mû en translation horizontale le long de la poutre 2, dans les deux sens indiqués par les flèches 15 et 16.

Sur la figure 1, le système est représenté relevé et en position neutre, chaque lame de raclage, supportée par un support de lame, faisant un angle de 45 degrés environ par rapport à un plan horizontal.

Le système de sérigraphie de la figure 1 comporte en outre un écran 17 sur lequel a été disposé automatiquement un cordon de crème ou de pâte à sérigraphier 18, et une table 19 porte un support plan 21 qui est pincé entre la table 19 et l'écran 17 qui est tendu et fait office de pochoir pour l'opération de sérigraphie à réaliser sur le support 21.

Le dessin de la figure 1 est très schématique et, en pratique, une entretoise (non représentée) solidaire du chariot 3 sert de support pour l'accrochage et le positionnement correct des supports de lames 6 et 7 avant leur serrage par la pince à l'aide des mâchoires 4, 5.

Partant de la position représentée à la figure 1, le fonctionnement du système est le suivant :
- Un léger basculement de la pince, dans le sens de la flèche 12 abaisse la lame 9 tout en relevant la lame 8.
- L'ensemble des éléments 4 à 9 est ensuite abaissé en direction de l'écran (flèche 14) jusqu'à ce que le bord libre de la lame 9 appuie, avec une pression prédéterminée, sur l'écran 17.
- Puis, l'ensemble des éléments 3 à 9 est entraîné vers la gauche dans le sens de la flèche 15. Dans ce mouvement, le cordon de crème 18 est entraîné par la lame 9 qui le pince contre l'écran 17.

Lors du passage sur le support à enduire 21, une partie de la crème est repoussée à travers des alvéoles (non visibles) de l'écran contre des emplacements prédéterminés du support 21, selon une configuration d'alvéoles représentée en 22 à la figure 2 A. La course de l'ensemble 3 à 9 s'arrête, sur la gauche du dessin à une abscisse à laquelle la lame 9 a dépassé l'extrémité gauche du support 21.
- L'ensemble 4 à 9 est relevé, ce qui laisse un cordon de crème sur l'écran 17, puis l'ensemble 4 à est basculé dans le sens de la flèche 11 jusqu'à une position où la lame 8 est plus basse que la lame 9, un nouveau support vient remplacer le support 21 et le mouvement du système se reproduit, symétriquement au précédent : abaissement selon la flèche 14 et translation selon la flèche 16.
- Après quoi, le cycle recommence, pour l'enduction de deux nouveaux supports tels que 21.

A chaque passage au-dessus d'un support à enduire, une petite partie de crème 18 est consommée à travers les alvéoles, et le cordon, tout en diminuant en volume, s'allonge le long de l'une (8) puis de l'autre lame (9). Après un petit nombre de passages le cordon va dépasser les bords des lames et va créer des cordons latéraux, parallèles au sens de déplacement du système (flèches 15 et 16). Ces cordons, non représentés sur la figure 1, constituent du produit qui sera perdu et dont la proportion par rapport au produit utile qui est déposé sur les supports tels que 21 est difficile à évaluer et à maîtriser. En effet, cette crème, qui n'est pas reprise par les lames, sèche et doit être enlevée et rebutée après un petit nombre de passages des lames de raclage (15 à 20 passages environ). Ceci implique une intervention manuelle fréquente, une perte de crème et rend l'utilisation d'un système d'approvisionnement automatique de crème à sérigraphier aléatoire car la crème ainsi rendue inutilisable n'est pas prise en compte.

La vue en plan de la figure 2 permet de situer le domaine d'application de l'invention. Pour ne pas compliquer le dessin, un seul support, 6, muni de sa lame 8 a été représenté, au-dessus de l'écran 17 qui est perforé selon la configuration d'alvéoles 22. A chaque extrémité du support 6 est fixée une joue dite de confinement de la crème, telle que 24, 25.

Ces joues sont positionnées, par rapport à la lame de raclage 8 (respectivement 9), de façon telle que lorsque la lame 8 est en pression sur l'écran 17 selon un angle et une force déterminée, leur bord libre appuie sur toute sa longueur avec une légère pression contre l'écran 17, ceci étant bien visible sur la section de la figure 2 B. Par ailleurs, vues de dessus, les joues présentent un évasement de l'arrière vers l'avant par rapport au sens de déplacement de la lame qu'elles enserrent, soit la direction 16 sur la figure 2 A. Ceci implique que, lors du passage en pression sur l'écran de la lame 8, la crème qui déborde à chaque extrémité est ramenée vers l'intérieur de l'écran, dans la zone de travail des lames. A cet effet, un léger espacement 30 est ménagé entre chaque extrémité de lame et la paroi intérieure de la joue correspondante, cet espacement étant de préférence de l'ordre de quelques millimètres et typiquement compris entre 1 et 10 mm. Le résultat de ce fonctionnement est visible sur la figure 2 A : lors du passage précédent de la lame 9 (non représentée) le cordon principal de crème 18 a été amené au-delà de la configuration de trous (d'alvéoles) 22 et occupe la position représentée, après relèvement de la lame 9. Dans le même temps, deux étroits cordons de crème 26 et 27 se sont formés latéralement, en conséquence du débordement de la crème par les côtés de la lame 9 et du recentrage dans la zone de travail des lames de cette crème, à l'arrière de la lame 9, par des joues non représentées telles que 24 et 25. Il est clair en effet que, lors du passage suivant de la lame 8 selon la direction 16, les cordons latéraux 26 et 27 seront repris par la lame 8 au même titre que le cordon principal 18. Ainsi, l'ensemble de la crème qui est disponible sur l'écran 17 est brassé à chaque passage de lame sur l'écran, un mélange s'opérant entre la crème du cordon principal 18 et celle des cordons latéraux 26 et 27, les trois cordons diminuant d'épaisseur à mesure que de la crème est consommée par chaque support tel que 21. De plus, la quantité de crème nécessaire peut être distribuée de façon périodique et de façon entièrement automatique, du fait que toute la crème approvisionnée sur l'écran est consommée par les supports 21, cette consommation étant connue avec précision.

On notera, sur la figure 2 A que, à chaque extrémité, le support de lame 6 dépasse légèrement l'extrémité correspondante de la lame 8. Ceci permet de manière non prévue par l'invention, de fixer par simple vissage, au moyen de vis telles que 28, 29, chaque joue contre chaque extrémité de support de lame. Si l'extrémité du support de lame est un plan perpendiculaire aux directions 15 ou 16, comme c'est le cas à la figure 2 A, la joue présente une face médiane droite à travers laquelle s'effectue le vissage de la joue et deux faces d'extrémité inclinées, l'ensemble de la joue revêtant la forme d'un S étiré et formant entonnoir de l'avant vers l'arrière par rapport à la direction du déplacement (flèche 16). Il serait aussi possible de manière non prévue par l'invention, de donner un léger biais de l'avant vers l'arrière aux surfaces d'extrémité des supports et de fixer à chaque extrémité, à titre de joue de confinement, une simple plaque plane en matériau souple, étant entendu qu'un léger espacement doit toujours être ménagé entre le bord de lame et la paroi intérieure de la joue correspondante. Cependant, une plaque deux fois coudée en forme de S, comme représenté à la figure 2 A, est préférée de façon que la circulation de la crème de l'avant vers l'arrière s'opère de façon optimale, à l'endroit même où la crème déborde l'extrémité de la lame.

De préférence, la plaque qui constitue chaque joue est réalisée en un matériau souple, de la matière plastique de préférence, tel que du chlorure de polyvinyle (PVC), d'une épaisseur comprise entre 1 et 4 mm.

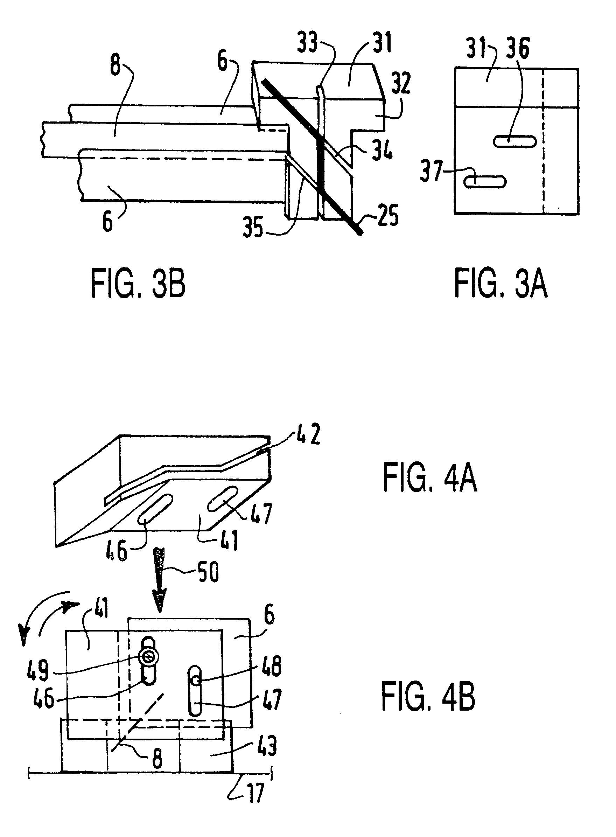

Un mode de réalisation de l'invention est représenté à la figure 3 B où seule une extrémité de lame 8 avec son support 6 et la joue de confinement 25 sont représentés, les 3 autres extrémités étant structurées de même, de façon identique ou symétrique.

Sur la figure 3 B l'extrémité de la lame et de son support 6 s'étendent dans un même plan vertical parallèle aux flèches 15 et 16 (non représentées). La joue de confinement 25 est sensiblement la même que sur la figure 2 mais ici, au lieu d'être directement fixée au support 6, elle comporte des moyens de fixation additionnels, tels que 31. La pièce 31 a la forme d'un T ; l'une de ses faces (la face inférieure (32)) est entaillée de façon à constituer une gorge de préférence sinueuse dans laquelle est enfoncée à force, par l'un de ses bords longs, la joue 25. Pour obtenir la forme en S préférée comme à la figure 2 la gorge peut être constituée par des parties de 3 gorges droites qui se recoupent, obtenues par sciage, telles la gorge droite 33 et les gorges obliques 34 et 35 ou bien par une gorge sinueuse (non représentée) ayant le profil désiré et obtenue par fraisage. Ces gorges ont une profondeur de 5 mm environ. Dans une direction sensiblement perpendiculaire à celle des gorges, deux boutonnières 36 et 37 sont pratiquées, à travers la jambe du T, en vue de la fixation de la pièce 31 à l'extrémité du support de lame 6. Cette fixation s'effectue au moyen d'une vis (non représentée) qui traverse librement la boutonnière 36 et d'un pion solidaire du support 6 (non visible sur la figure) qui traverse librement la boutonnière 37. Le mode de fixation, identique à un autre mode de réalisation préféré de l'invention est décrit ci-dessous en référence à la figure 4.

Le mode de réalisation de la figure 3 présente l'avantage de pouvoir réaliser les 4 pièces 31 nécessaires à partir d'une même pièce 31 qui présente des symétries de par sa forme en T. Il a par contre l'inconvénient de laisser un passage inutilement grand, de l'ordre de 1 cm, pour la crème entre la lame et la joue alors qu'on préfère un espacement plus réduit et inférieur à 5 mm entre ces deux éléments. Le mode de réalisation de la figure 4 permet de réduire ledit espacement à 2 ou 3 mm seulement.

Sur la figure 4, les moyens de fixation sont constitués par une pièce 41 de forme sensiblement parallélépipédique, moins massive que la pièce 31. Sa face inférieure comporte une gorge sinueuse 42 destinée à recevoir la joue 43 pour la maintenir et lui donner sa forme en S étiré. On notera cependant que la gorge 42 pourraît être aussi droite, tout en étant légèrement inclinée de façon qu'elle occupe pour l'essentiel le même emplacement que la gorge 42. La pièce 41 comporte, en direction perpendiculaire à celle de la gorge, deux boutonnières 46, 47 semblables aux boutonnières 36 et 37 de la figure 3 A et ayant les mêmes fonctions.

Pour la fixation de la pièce 41 munie de la joue 43 à l'extrémité du support 6, on la prépositionne au moyen d'un pion 48 dans la boutonnière 47, le pion étant solidaire du support 6, et de l'association d'une vis et d'une rondelle, 49, à travers la boutonnière 46, avec les cotes relatives indiquées sur la figure, à savoir le bord libre de la joue 43 touchant l'écran 17 alors que la lame 8 ne touche pas encore ce dernier et la vis 49 étant légèrement serrée. Une force indiquée par la flèche 50 fait ensuite appliquer la lame 8 contre l'écran avec l'angle et la pression nominaux. Pendant ce mouvement la pièce 41 s'est relevée, par rapport au support 6 et appuie le bord libre de la joue 43, c'est-à-dire conformément à l'angle optimal de la lame par rapport à l'écran, avec une légère pression, contre l'écran 17. Elle est alors fixée fermement par serrage de la vis 49. Il est clair que si l'angle que fait la lame 8 avec l'écran 17 devait être modifié, le positionnement des 4 joues devrait être repris, comme décrit ci-dessus.

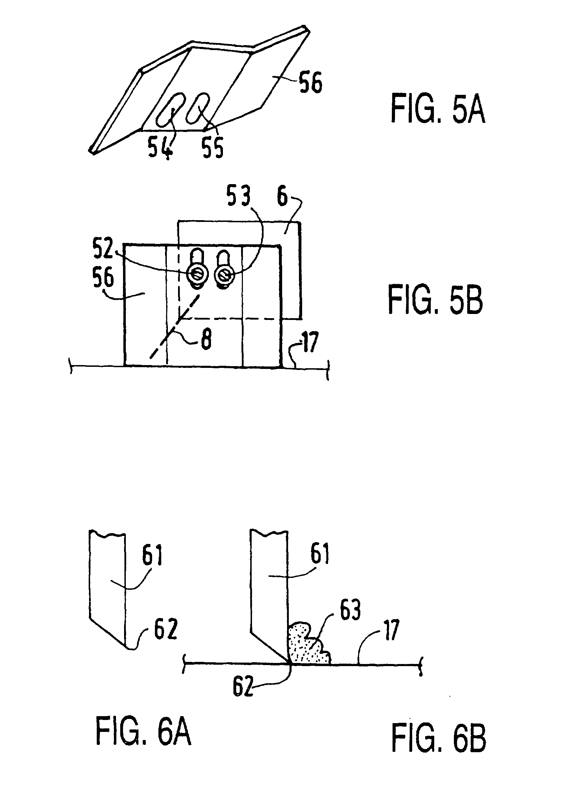

Le mode de réalisation de la figure 5 ne faisant pas partie de l'invention, est, pour l'essentiel, celui représenté à la figure 2. Les moyens de fixation y sont réduits à deux vis associées à des rondelles 52 et 53 qui traversent des boutonnières 54, 55 pratiquées dans la joue ou plaque 56. La forme en S de la figure 5 A peut être obtenue par exemple par pliage à chaud d'une plaque plane en PVC souple. Si le bord du support 6 dépasse légèrement celui de la lame 8, comme représenté à la figure 2, la plaque 56 peut être fixée directement contre ce bord, sinon une cale (non représentée) peut être interposée entre la joue et le bord du support, avec léger serrage dans un premier temps des vis 52 et 53, comme décrit en référence à la figure 4, pour le positionnement correct de la joue 56 qui s'opère de façon analogue à celui de la joue 43.

Pour éviter que, suite à une force d'appui insuffisante du bord libre de la joue contre l'écran 17, cette joue laisse fuir, en fonctionnement, de la crème à sérigraphier qui traverserait ce bord libre et ne pourrait plus ensuite être reprise efficacement, il est possible de perfectionner la joue, pour tous les modes de réalisaton décrits ci-dessus, en donnant une forme particulière à son bord libre.

Ce perfectionnement, représenté à la figure 6, consiste à tailler en biseau, de l'extérieur vers l'intérieur le bord libre de la joue 61. Dans ces conditions, seule une arête 62 située le long de la face interne de la plaque est au contact de l'écran 17, lors du fonctionnement. Cette arête est déviée légèrement vers l'intérieur et agit comme un racloir travaillant en cisaillement contre la crème 63, ce qui empêche le passage de cette dernière sous le bord de la joue.

La façon de positionner une joue de confinement contre une extrémité de support de lame pour une bonne mise en oeuvre de l'invention a été décrite ci-dessus en référence à la figure 4. Pour les modes de réalisation des figures 3 et 4, un perfectionnement de l'invention consiste à réaliser des moyens de fixation de joue tels que 31 et 41 en une matière plastique élastique telle qu'un élastomère, c'est-à-dire du caoutchouc naturel ou synthétique. Ceci offre l'avantage de n'avoir pas à recommencer le positionnement des joues contre les supports de lame lorsque l'angle d'attaque des lames 8, 9 est modifié de quelques (2 ou 3) degrés par rapport à l'écran 17.

L'invention s'applique à tout système de sérigraphie automatique à deux lames de raclage travaillant en opposition. Une application préférée cependant, qui est adaptée à la technique CMS (Composants pour Montage en Surface) est celle selon laquelle l'opération de sérigraphie consiste à déposer une pâte à souder sur des plages de contact prévues sur un circuit imprimé ou un circuit hybride. Dans ces conditions, la pâte à souder qui constitue le produit de sérigraphie ou crème est constitué par exemple de petites billes en alliage de Pb-Sn de quelques microns de diamètre, agglomérées au moyen d'un liant qui confère à cette pâte des qualités thyxotropiques et l'écran est constitué d'une feuille mince en acier inoxydable de 180 µm ou 150 µm d'épaisseur, munie des plages de contact prévues sur le circuit imprimé ou le circuit hybride à enduire.

## Revendications

1. Système de sérigraphie automatique à deux lames de raclage (8,9) travaillant en opposition et qui sont fixées chacune à un support de lame (6,7), pour déposer un produit de sérigraphie (18) selon une configuration donnée sur un support (21) à enduire, à travers un écran (17) à positionner sur ledit support, ledit écran (17) étant perforé selon ladite configuration, chaque extrémité de support de lame (6,7) comportant des moyens (31-35,41) de fixation d'une joue (25,43) de confinement du produit de sérigraphie, un léger espacement étant ménagé entre le bord latéral de la lame de raclage et la joue (25,43), cette dernière étant orientée de façon à ramener vers l'intérieur de l'écran, dans la zone de travail des lames, le produit de sérigraphie qui dépasse l'extrémité de la lame lors de son passage en pression sur l'écran (17), **caractérisé en ce que** lesdits moyens de fixation consistent en un support de joue (31,41) fixé par vissage à ladite extrémité de support de lame (6,7), comprenant une rainure (33-35,42) dans laquelle est enfoncée à force une plaque en matériau souple faisant office de joue (25,43) qui en fonctionnement appuie par son bord libre contre ledit écran (17).

2. Système de sérigraphie automatique selon la revendication 1, **caractérisé en ce que** lesdits moyens de fixation comportent des moyens de réglage (36-37,46-49) permettant d'ajuster la position dudit support de joue (31,41) sur ladite extrémité de support de lame (6,7), pour obtenir le contact, en fonctionnement, entre le bord libre de ladite joue (25,43) et ledit écran (17).

3. Système de sérigraphie automatique selon l'une des revendications 1 à 2, **caractérisé en ce que** chaque plaque (25,43) revêt, selon une section parallèle audit écran (17), la forme générale d'un S étiré après sa fixation sur le support de joue (31,41).

4. Système de sérigraphie automatique selon l'une des revendications 1 à 3, **caractérisé en ce que** le bord libre de chaque plaque est taillé en biseau, de l'extérieur vers l'intérieur du système de façon que seule une arête située le long de la face interne de la plaque (25,43) soit au contact de l'écran (17), lors du fonctionnement.

5. Système de sérigraphie automatique selon l'une des revendications 1 à 4, **caractérisé en ce que** chaque plaque (25,43) constituant la joue est en chlorure de polyvinyle d'une épaisseur comprise entre 1 et 4 mm.

6. Système de sérigraphie automatique selon l'une des revendications 1 à 5, **caractérisé en ce que** ledit espacement ménagé entre chaque bord de lame de raclage (8,9) et chaque plaque (25,43) constituant la joue est compris entre 1 et 10 mm.

7. Système de sérigraphie automatique selon l'une des revendications 1 à 6, destiné à déposer une pâte à souder (18) sur des plages de contact d'un circuit imprimé, dans lequel l'écran (17) est constitué par une mince feuille en acier inoxydable munie d'alvéoles (22) disposées au-dessus desdites plages de contact.

## Patentansprüche

1. Automatisches Siebdrucksystem mit zwei gegenläufig arbeitenden Abstreichklingen (8, 9), die jeweils an einem Klingenträger (6, 7) befestigt sind, um ein Siebdruckprodukt (18) nach einer bestimmten Konfiguration auf einen zu bestreichenden Träger (21) zu geben, über einen auf dem besagten Träger auszurichtenden Schirm (17), wobei der besagte Schirm (17) nach der besagten Konfiguration gelocht ist, jedes Klingenträgerende (6, 7) Verfahren (31- 35, 41) zur Befestigung einer Backe (25, 43) zur Trennung des Siebdruckprodukts aufweist, ein kleiner Abstand zwischen dem Seitenrand der Abstreichklinge und der Backe (25, 43) vorgesehen und dieser letztere ausgerichtet ist, um das Siebdruckprodukt, das beim Durchgang der auf den Schirm (17) drückenden Klinge über deren Ende hinausgeht, ins Schirminnere, in den Arbeitsbereich der Klingen, zurückzubringen, **dadurch gekennzeichnet, daß** die besagten Befestigungsverfahren aus einem Backenträger (31, 41) bestehen, mit Schrauben an dem besagten Klingenträgerende (6, 7) befestigt, mit einer Rille (33 - 35, 42), in der eine Platte aus elastischem Material eingedrückt ist, die als Backe (25, 43) dient, die beim Betrieb mit ihrem freien Rand gegen den besagten Schirm (17) drückt.

2. Automatisches Siebdrucksystem nach Anspruch 1, **dadurch gekennzeichnet, daß** die besagten Befestigungsverfahren Einstellverfahren (36 - 37, 46 - 49) enthalten, die eine Anpassung der Stellung des besagten Backenträgers (31, 41) auf dem besagten Klingenträgerende (6, 7) ermöglichen, um beim Betrieb zwischen dem freien Rand der besagten Bakke (25, 43) und dem besagten Schirm (17) eine Verbindung herzustellen.

3. Automatisches Siebdrucksystem nach einem der Ansprüche 1 bis 2, **dadurch gekennzeichnet, daß** jede Platte (25, 43) nach einem zu dem besagten Schirm (17) parallelen Schnitt eine allgemeine S-Form hat, nach der Befestigung ihres Backenträgers (31, 41) gestreckt.

4. Automatisches Siebdrucksystem nach einem der Ansprüche 1 bis 3, **dadurch gekennzeichnet, daß** der freie Rand jeder Platte abgeschrägt ist, von außen nach innen des Systems, damit beim Betrieb eine einzige Kante entlang der Innenseite der Platte (25, 43) mit dem Schirm (17) in Berührung ist.

5. Automatisches Siebdrucksystem nach einem der Ansprüche 1 bis 4, **dadurch gekennzeichnet, daß** jede Platte (25, 43) zur Bildung der Backe aus Polyvinylchlorid mit einer zwischen 1 und 4 mm enthaltenen Dicke ist.

6. Automatisches Siebdrucksystem nach einem der Ansprüche 1 bis 5, **dadurch gekennzeichnet, daß** der besagte vorgesehene Abstand zwischen jedem Abstreichklingenrand (8, 9) und jeder Platte (25, 43) zur Bildung der Backe zwischen 1 und 10 mm enthalten ist.

7. Automatisches Siebdrucksystem nach einem der Ansprüche 1 bis 6, um eine Schweißpaste (18) auf die Kontaktabschnitte einer gedruckten Schaltung zu geben, wobei der Schirm (17) aus einem dünnen Blatt aus rostfreiem Stahl gebildet wird, mit Hohlräumen (22) versehen, die über den besagten Kontaktabschnitten vorgesehen sind.

## Claims

1. An automatic screen printing system having two oppositely working scraping blades (8,9) which are each fixed to a blade support (6,7) for depositing a screen printing product (18) in accordance with a given configuration on a support (21) to be coated via a screen (17) to be positioned on said support, said screen (17) being perforated in accordance with said configuration, each extremity of the blade support (6,7) comprising means (31-35,41) for fixing a confinement cheek (25,43) for the screen printing product, a small spacing being saved between the lateral edge of the scraping blade and the cheek (25,43), the latter being oriented so as to bring the screen printing product, which passes beyond the extremity of the blade during its passage under pressure on the screen (17), back to within the screen in the work zone of the blades, **characterized in that** said fixation means consist of a cheek support (31,41) fixed by means of screwing to said extremity of the blade support (6,7), said cheek support having a groove (33-35,42) in which a plate of flexible material acting as the cheek (25,43) is inserted with force, which, in operation, engages said screen (17) with its free edge.

2. An automatic screen printing system as claimed in claim 1, **characterized in that** said fixation means comprise adjusting means (36-37,46-49) allowing adjustment of the position of said cheek support (31,41) on said extremity of the blade support (6,7) for obtaining contact, in operation, between the free edge of said cheek (25,43) and said screen (17).

3. An automatic screen printing system as claimed in any one of claims 1 to 2, **characterized in that**, after its fixation on the cheek support (31,41), each plate (25,43) assumes the general shape of a drawn S in accordance with a section which is parallel to said screen (17).

4. An automatic screen printing system as claimed in any one of claims 1 to 3, **characterized in that** the free edge of each plate is chamfered from the outside to the inside of the system, such that only a ridge situated along the internal face of the plate (25,43) is in contact with the screen (17) during operation.

5. An automatic screen printing system as claimed in any one of claims 1 to 4, **characterized in that** each plate (25,43) constituting the cheek is made of polyvinyl chloride having a thickness of between 1 and 4 mm.

6. An automatic screen printing system as claimed in any one of claims 1 to 5, **characterized in that** said spacing saved between each edge of the scraping blade (8,9) and each plate (25,43) constituting the cheek is between 1 and 10 mm.

7. An automatic screen printing system as claimed in any one of claims 1 to 6, intended to deposit a soldering paste (18) on contact areas of a printed circuit board, wherein the screen (17) is constituted by a thin foil of stainless steel provided with cavities (22) arranged above said contact areas.
